# EUROPEAN PATENT APPLICATION

(11) **EP 4 178 331 A1**
(43) Date of publication of application: **10.05.2023**
(21) Application number: 22205825.7
(22) Date of filing: 07.11.2022
(51) Int. Cl.: H10K 59/38, H01L 25/075, H01L 33/50

(54) **DISPLAY DEVICE, ELECTRONIC DEVICE, AND FABRICATION METHOD THEREOF**

(30) Priority: 09.11.2021 KR 20210152884
(71) Applicant: Samsung Electronics Co., Ltd., Gyeonggi-do 16677 (KR)
(72) Inventor: CHUNG, Deuk Seok, Suwon-si (KR); KIM, Tae-Gon, Suwon-si (KR); PARK, Shang Hyeun, Suwon-si (KR); BAE, Min Jong, Suwon-si (KR); WON, Jong Hoon, Suwon-si (KR); JUN, Shin Ae, Suwon-si (KR); JO, A Ra, Suwon-si (KR)
(74) Representative: Elkington and Fife LLP

(57) **Abstract**

The present disclosure provides a display panel including: a substrate; a plurality of light emitting elements including semiconductor light emitting chips and disposed on the substrate; a plurality of color conversion layers overlapped with the plurality of light emitting elements and disposed thereon, respectively; and a plurality of absorption-type color filter layers directly disposed and having a surface shape of the plurality of color conversion layers, respectively, where a pitch between adjacent light emitting elements of the plurality of light emitting elements is less than or equal to about 100 micrometers, and at least one of the plurality of color conversion layers includes quantum dots.

## Description

### FIELD OF THE INVENTION

The present disclosure relates to a display panel, an electronic device, and a fabrication method thereof.

### BACKGROUND OF THE INVENTION

An electronic device including a display panel such as a liquid crystal display panel, a plasma display panel, or an organic light emitting display panel has been commercialized.

Research on a display panel including semiconductor nanocrystals called quantum dots is being conducted.

### SUMMARY OF THE INVENTION

According to an embodiment, provided is a display panel including: a plurality of self-emission type color conversion layers overlapped on a plurality of fine light emitting elements such as micro light emitting diodes, and a plurality of absorption-type color filter layers formed on the plurality of self-emission type color conversion layers, where the plurality of absorption-type color filter layers are formed directly on the plurality of self-emission type color conversion layers, a planarization layer is not disposed between the plurality of self-emissive color conversion layers and the plurality of absorption-type color filter layers, and in addition, a separate adhesive layer between the plurality of self-emission type color conversion layers and the plurality of light emitting elements is not included, thereby providing a display panel having improved processability, thinner and lighter, and improved light efficiency.

Another embodiment provides an electronic device including the display panel.

Another embodiment provides a method of fabricating the display panel.

A display panel according to an embodiment includes: a substrate; a plurality of light emitting elements each including semiconductor light emitting chip and disposed on the substrate; a plurality of color conversion layers overlapped with and disposed on the plurality of light emitting elements, respectively; and a plurality of absorption-type color filter layers directly disposed on and having a surface shape of the plurality of color conversion layers, respectively, where a pitch between adjacent light emitting elements of the plurality of light emitting elements is less than or equal to about 100 micrometers, and at least one of the plurality of color conversion layers includes quantum dots.

The plurality of color conversion layers may include first color conversion layers including first quantum dots configured to convert light emitted from first light emitting elements of the plurality of light emitting elements into a first light of a first emission spectrum, and the first light emitting elements may overlap with the first color conversion layers and be electrically connected to each other.

The plurality of color conversion layers may further include second color conversion layers including second quantum dots configured to convert light emitted from second light emitting elements of the plurality of light emitting elements into a second light of a second emission spectrum that differs from the first emission spectrum, and the second light emitting elements may overlap with the second color conversion layers and be electrically connected to each other.

The plurality of color conversion layers may further include a plurality of light transmission layers configured to transmit a third light of an emission spectrum emitted from third light emitting elements of the plurality of light emitting elements as it is, and
the third light emitting elements may overlap with the plurality of light transmission layers and be electrically connected to each other.

A central wavelength of light emitted by each of the plurality of light emitting elements may be about 430 nanometers to about 470 nanometers.

Each of the plurality of absorption-type color filter layers may include a pigment, a dye, or a combination thereof.

The plurality of absorption-type color filter layers may include a photo initiator.

Each of the plurality of absorption-type color filter layers may include a pigment, a dye, or a combination thereof, and a photo initiator, which are dispersed in a polymer matrix.

The at least one of the plurality of color conversion layers may include a plurality of quantum dots dispersed in a polymer matrix.

The plurality of light emitting elements include a plurality of micro light emitting diodes which emit blue light, and the plurality of color conversion layers include first color conversion layers including red light-emitting quantum dots dispersed in a polymer matrix, and second color conversion layers including green light-emitting quantum dots dispersed in a polymer matrix.

An electronic device according to another embodiment includes the display panel according to the embodiment.

In addition, a method of fabricating a display panel according to another embodiment includes: preparing a substrate including a plurality of light emitting elements each including a semiconductor light emitting chip, and a first color conversion layer including first quantum dots and disposed on a first light emitting element of the plurality of light emitting elements; forming a first photosensitive resin layer including a pigment, a dye, or a combination thereof of a first color on the first color conversion layer; and driving the first light emitting element on which the first color conversion layer is disposed to cure the first photosensitive resin layer with light emitted from the first light emitting element to form a first absorption-type color filter layer on the first color conversion layer.

A central wavelength of light emitted by each of the plurality of light emitting elements may be about 430 nanometers to about 470 nanometers.

The substrate including the first color conversion layer may further include a second color conversion layer comprising second quantum dots and disposed on a second light emitting element of the plurality of light emitting elements, which is different from the first light emitting element.

The fabricating method may further include: forming a second photosensitive resin layer including a pigment, a dye, or a combination thereof of a second color on the second color conversion layer, and driving the second light emitting element on which the second color conversion layer is disposed to cure the second photosensitive resin layer with light emitted from the second light emitting element to form a second absorption-type color filter layer on the second color conversion layer.

The substrate may further include a light transmission layer disposed on a third light emitting element of the plurality of light emitting elements, which is different from the first and second light emitting elements.

The fabricating method may further include, (i) after forming a third photosensitive resin layer comprising a pigment, a dye, or a combination thereof of a third color on the light transmission layer, driving the third light emitting element on which the light transmission layer is disposed to cure the third photosensitive resin layer with light emitted from the third light emitting element to form a third absorption-type color filter layer, (ii) after forming a second photosensitive resin layer comprising a pigment, a dye, or a combination thereof of a second color on the second color conversion layer, driving the second light emitting element on which the second color conversion layer is disposed to cure the second photosensitive resin layer with light emitted from the second light emitting element to form a second absorption-type color filter layer, or (iii) performing both processes (i) and (ii) to form both the third absorption-type color filter layer and the second absorption-type color filter layer.

Each of the first, second and third light emitting elements and the first and second color conversion layers, and the light transmission layer may be provided in plurality, and the plurality of first light emitting elements may be formed on the first color conversion layers, the plurality of second light emitting elements may be formed on the second color conversion layers, and the plurality of third light emitting elements may be formed on the light transmission layers, and the plurality of first light emitting elements may be electrically connected to each other, the plurality of second light emitting elements may be electrically connected to each other, and the plurality of third light emitting elements may be electrically connected to each other.

At least one of the first absorption-type color filter layer, the second absorption-type color filter layer, and the third absorption-type filter layer includes a photo initiator that reacts at a central wavelength of light emitted by the plurality of light emitting elements.

In a display panel according to an embodiment, a plurality of self-emission type color conversion layers on the plurality of light emitting elements and a plurality of absorption-type color filter layers on the plurality of self-emission type color conversion layers do not include an adhesive layer or a planarization layer between each layer. That is, in the display panel according to the embodiment, a plurality of self-emission type color conversion layers are disposed directly on the plurality of light emitting elements, and a plurality of absorption-type color filter layers are directly disposed on and having a surface shape of the plurality of self-emission type color conversion layers. Accordingly, the display panel according to the embodiment has a thinner thickness, lighter weight, a simpler fabricating process, lower fabricating cost, and more improved color purity and light efficiency than a display panel including a conventional self-emission type color conversion layer. Accordingly, the display panel according to the embodiment may be advantageously applied to various electronic devices.

### BRIEF DESCRIPTION OF THE DRAWINGS

FIG. 1 is a plan view illustrating an example of a pixel arrangement of a display panel according to an embodiment.
FIG. 2 is a schematic cross-sectional view of a display panel according to an embodiment.
FIGS. 3 to 5 are cross-sectional views each showing an example of a light emitting element.
FIG. 6 is a schematic cross-sectional view of a display panel according to the conventional art.
FIGS. 7 to 10 are cross-sectional views schematically illustrating a fabricating process of a display panel according to an embodiment.

### DETAILED DESCRIPTION

Hereinafter, referring to the drawings, embodiments of the present invention are described in detail. In the following description of the present invention, the well-known functions or constructions may be omitted in order to clarify the present invention. The present disclosure may be embodied in several different forms, and is not limited to the embodiments described herein.

In order to clearly illustrate the present disclosure, the description and relationships are omitted, and throughout the disclosure, the same or similar configuration elements are designated by the same reference numerals. Also, since the size and thickness of each configuration shown in the drawing are arbitrarily shown for better understanding and ease of description, the present invention is not necessarily limited thereto.

In the drawings, the thickness of layers, films, panels, regions, etc., are exaggerated for clarity. In addition, the thicknesses of some layers and regions are exaggerated for convenience of explanation. It will be understood that when an element such as a layer, film, region, or substrate is referred to as being "on" another element, it can be directly on the other element or intervening elements may also be present. In contrast, when an element is referred to as being "directly on" another element, there are no intervening elements present. Also, to be disposed "on" the reference portion means to be disposed above or below the reference portion, and does not necessarily mean "above" in an opposite direction of gravity.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. In addition, unless explicitly described to the contrary, the word "comprise" and variations such as "comprises" or "comprising" will be understood to imply the inclusion of stated elements but not the exclusion of any other elements.

Further, in the entire specification, the term "plan view" means a case in which a target part is viewed from the top, and the term "cross-sectional view" means a case in which a cross-section of the target part that is cut in a vertical direction is viewed from the side.

Hereinafter, the term "combination" refers to a mixture and a stacked structure of two or more.

Hereinafter, a display panel according to an embodiment is described with reference to the drawings.

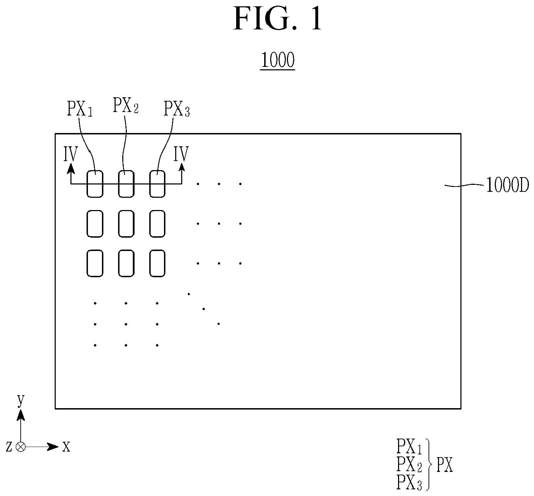

FIG. 1 is a plan view illustrating an example of a pixel arrangement of a display panel according to an embodiment.

Referring to FIG. 1, in a display panel 1000 according to an embodiment, a plurality of pixels PXs are arranged on a substrate 1000D.

A plurality of pixels PXs are arranged along a row (e.g., x-direction) and/or column (e.g., y-direction) on the substrate 1000D, and each pixel PX includes a plurality of subpixels PX₁, PX₂, and PX₃ configured to display different colors. Herein, as an example, a configuration in which three subpixels PX₁, PX₂, and PX₃ constitute one pixel PX is illustrated, but the configuration is not limited thereto. An additional subpixel such as a white subpixel may be further included, and one or more subpixel configured to display the same color may be included. The plurality of pixels PXs may be arranged in, for example, a Bayer matrix, a PenTile matrix, and/or a diamond matrix, but is not limited thereto.

Each of the subpixels PX₁, PX₂, and PX₃ may be configured to display three primary colors or a combination of three primary colors, respectively, for example, red, green, blue, or a combination thereof. For example, the first subpixel PX₁ may be configured to display red, the second subpixel PX₂ may be configured to display green, and the third subpixel PX₃ may be configured to display blue.

In the drawing, an example in which all subpixels have the same size is illustrated, but the present disclosure is not limited thereto. At least one of the subpixels may be larger or smaller than the other subpixels. In the drawing, an example in which all subpixels have the same rectangular shape is illustrated, but the present disclosure is not limited thereto, and at least one of the subpixels may have a shape different from that of the other subpixels, for example, a hemisphere (or semicircle), oval, or hexagonal shape.

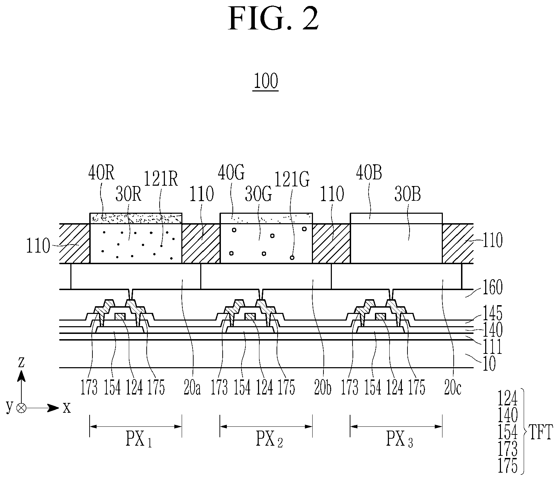

FIG. 2 is a cross-sectional view of the display panel taken along line IV-IV of FIG. 1, illustrating a cross-section of the display panel according to an embodiment.

Referring to FIG. 2, a display panel 100 according to an embodiment includes a substrate 10, a buffer layer 111, a thin film transistor TFT, a plurality of light emitting elements 20a, 20b, and 20c, color conversion layers 30R, 30G, and 30B including quantum dots 121R and 121G overlapped with and directly disposed on light emitting elements 20a, 20b, and 20c, respectively, and an absorption-type color filter layers 40R, 40G, 40B disposed directly on the color conversion layers 30R, 30G, and 30B, respectively.

The substrate 10 may be a transparent substrate. For example, the substrate 10 may include an organic material, an inorganic material, or an organic-inorganic material, for example, an oxide, a nitride, or an oxynitride, for example, silicon oxide, silicon nitride, silicon oxynitride, or a combination thereof, but is not limited thereto. In an embodiment, the substrate may include sapphire (Al₂O₃), gallium nitride (GaN), silicon carbide (SiC), gallium oxide (Ga₂O₃), lithium gallium oxide (LiGaO₂), lithium aluminum oxide (LiAlO₂), magnesium aluminum oxide (MgAl₂O₄), or the like. In addition, when the substrate includes an organic material, it may include a polymer, for example, polyacryl, polyimide, polyamide, polyamideimide, polyethylene terephthalate, polyethylene naphthalene, polymethyl methacrylate, polycarbonate, a copolymer thereof, or a combination thereof, but is not limited thereto.

The buffer layer 111 may include an organic material, an inorganic material, or an organic-inorganic material, and for example, may include an oxide, nitride, or oxynitride, for example, silicon oxide, silicon nitride, silicon oxynitride, or a combination thereof, but is not limited thereto. The buffer layer 111 may be one layer or two or more layers, and may cover the whole surface of the substrate 10. The buffer layer 111 may be omitted.

The thin film transistor TFT may be a three-terminal device for switching and/or driving the light emitting elements 20a, 20b, and 20c, and may include one or two or more for each subpixel. The thin film transistor TFT may include a gate electrode 124, a semiconductor layer 154 overlapped with the gate electrode 124, a gate insulating layer 140 between the gate electrode 124 and the semiconductor layer 154, and a source electrode 173 and a drain electrode 175 electrically connected to the semiconductor layer 154. In FIG. 2, a coplanar top gate structure is shown as an example, but the structure is not limited thereto and may have various structures.

The gate electrode 124 is electrically connected to a gate line (not shown), and may include, for example, a low-resistance metal such as aluminum (Al), molybdenum (Mo), copper (Cu), titanium (Ti), silver (Ag), gold (Au), an alloy thereof, or a combination thereof, but is not limited thereto.

The semiconductor layer 154 may be an inorganic semiconductor such as amorphous silicon, polycrystalline silicon, or oxide semiconductor; an organic semiconductor; an organic-inorganic semiconductor; or a combination thereof. For example, the semiconductor layer 154 may include an oxide semiconductor including at least one of indium (In), zinc (Zn), tin (Sn), and gallium (Ga), and the oxide semiconductor may include, for example, indium-gallium-zinc oxide, zinc-tin oxide, or a combination thereof, but they are not limited thereto. The semiconductor layer 154 may include a channel region and doped regions disposed on both sides of the channel region and electrically connected to the source electrode 173 and the drain electrode 175, respectively.

The gate insulating layer 140 may include an organic material, an inorganic material, or an organic-inorganic material, and may include, for example, an oxide, a nitride, or an oxynitride, and may include, for example, silicon oxide, silicon nitride, silicon oxynitride, or a combination thereof, but is not limited thereto. In the drawing, an example in which the gate insulating layer 140 is formed on the entire surface of the substrate 10 is illustrated, but the present disclosure is not limited thereto and may be selectively formed between the gate electrode 124 and the semiconductor layer 154. The gate insulating layer 140 may be formed of one or two or more layers.

The source electrode 173 and the drain electrode 175 may include, for example, a low-resistance metal such as aluminum (Al), molybdenum (Mo), copper (Cu), titanium (Ti), silver (Ag), gold (Au), an alloy thereof, or a combination thereof, but are not limited thereto. The source electrode 173 and the drain electrode 175 may be electrically connected to the doped regions of the semiconductor layer 154, respectively. The source electrode 173 is electrically connected to a data line (not shown), and the drain electrode 175 is electrically connected to each of light emitting elements 20a, 20b, and 20c.

An interlayer-insulating layer 145 is additionally formed between the gate electrode 124 and the source/drain electrodes 173 and 175. The interlayer-insulating layer 145 may include an organic material, an inorganic material, or an organic-inorganic material, for example, oxide, nitride, or oxynitride, for example, silicon oxide, silicon nitride, silicon oxynitride, or a combination thereof, but is not limited thereto. The interlayer-insulating layer 145 may be formed of one or two or more layers.

A protective layer 160 is formed on the thin film transistor TFT. The protective layer 160 may be, for example, a passivation layer. The protective layer 160 may include an organic material, an inorganic material, or an organic-inorganic material, for example, polyacrylic, polyimide, polyamide, polyamideimide, or a combination thereof, but is not limited thereto. The protective layer 160 may be formed of one or two or more layers.

A plurality of light emitting elements 20a, 20b, and 20c may be disposed for the plurality of subpixels PX₁, PX₂, and PX₃, respectively. Each of light emitting elements 20a, 20b, and 20c disposed in the corresponding one of the subpixels PX₁, PX₂, and PX₃ may independently be driven by applied power or a driving signal to emit light. Each of the light emitting elements 20a, 20b, and 20c may include, for example, a semiconductor light emitting chip, such as, a light emitting diode ("LED"), and may include a pair of electrodes, and a light emitting layer disposed between the pair of electrodes. The light emitting layer may include a light emitting body capable of emitting light of a predetermined wavelength region, for example, a light emitting body that emits light of an emission spectrum belonging to a visible light wavelength spectrum, for example, blue light. The light emitting body may include an organic light emitting body, an inorganic light emitting body, an organic-inorganic light emitting body, or a combination thereof, and may be one type or two or more types.

The light emitting elements 20a, 20b, and 20c may be, for example, an organic light emitting diode ("OLED"), an inorganic light emitting diode, or a combination thereof, and the inorganic light emitting diode may be, for example, a quantum dot light emitting diode, a perovskite light emitting diode, a micro light emitting diode, an inorganic nano light emitting diode, or a combination thereof, but is not limited thereto.

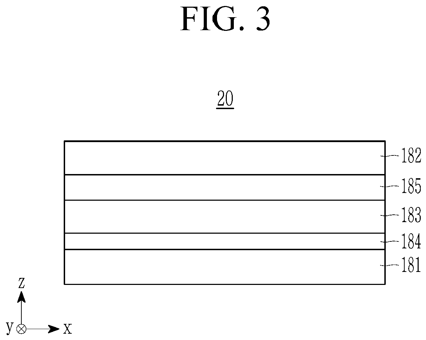

FIGS. 3 to 5 are cross-sectional views each showing an example of a light emitting element.

Referring to FIG. 3, the light emitting element 20 includes a first electrode 181 and a second electrode 182 facing each other; a light emitting layer 183 between the first electrode 181 and the second electrode 182; and optionally auxiliary layers 184 and 185 between the first electrode 181 and the light emitting layer 183 and between the second electrode 182 and the light emitting layer 183.

The first electrode 181 and the second electrode 182 may be disposed to face each other along a thickness direction (for example, z-direction), and any one of the first electrode 181 and the second electrode 182 may be an anode and the other may be a cathode. The first electrode 181 may be a light transmitting electrode, a transflective electrode, or a reflecting electrode, and the second electrode 182 may be a light transmitting electrode or a transflective electrode. The light transmitting electrode or transflective electrode may be, for example, made of a thin single layer or multiple layers of metal thin film including conductive oxides such as indium tin oxide ("ITO"), indium zinc oxide ("IZO"), zinc oxide (ZnO), tin oxide (SnO), aluminum tin oxide (AITO), and fluorine-doped tin oxide ("FTO") or silver (Ag), copper (Cu), aluminum (Al), magnesium (Mg), magnesium-silver (Mg-Ag), magnesium-aluminum (Mg-AI), or a combination thereof. The reflecting electrode may include a metal, a metal nitride, or a combination thereof, for example, silver (Ag), copper (Cu), aluminum (Al), gold (Au), titanium (Ti), chromium (Cr), nickel (Ni), an alloy thereof, a nitride thereof (e.g., TiN), or a combination thereof, but is not limited thereto.

The light emitting layer 183 may include a light emitting body capable of emitting light of a first emission spectrum. The first emission spectrum may belong to a relatively short wavelength region of the visible light wavelength spectrum, and may be, for example, a blue emission wavelength. A maximum emission wavelength of blue emission wavelength may belong to a wavelength region of greater than or equal to about 400 nanometer (nm) and less than about 500 nm, within the range, about 410 nm to about 490 nm, about 420 nm to about 480 nm, or about 430 nm to about 470 nm. The light emitting body may be one or two or more types.

For example, the light emitting layer 183 may include a host material and a dopant material.

For example, the light emitting layer 183 may include a phosphorescent material, a fluorescent material, or a combination thereof.

For example, the light emitting body may include an organic light emitting body, and the organic light emitting body may be a low molecular weight compound, a polymer, or a combination thereof. When the light emitting body includes an organic light emitting body, the light emitting elements 20a, 20b, and 20c may be an organic light emitting diode.

For example, the light emitting body may include an inorganic light emitting body, and the inorganic light emitting body may be an inorganic semiconductor, quantum dot, perovskite, or a combination thereof. When the light emitting body includes an inorganic light emitting body, the light emitting elements 20a, 20b, and 20c may be a quantum dot light emitting diode, a perovskite light emitting diode, or a micro light emitting diode.

In an embodiment, the light emitting body may include an inorganic light emitting body, and each of the plurality of light emitting elements 20a, 20b, and 20c may be a micro light emitting diode.

The auxiliary layers 184 and 185 may be disposed between the first electrode 181 and the light emitting layer 183 and between the second electrode 182 and the light emitting layer 183, respectively, and may be a charge auxiliary layer to control injection and/or mobility of charges, respectively. Each of the auxiliary layers 184 and 185 may be one or two or more layers, and may be, for example, a hole injection layer, a hole transport layer, an electron blocking layer, an electron injection layer, an electron transport layer, a hole blocking layer, or a combination thereof. At least one of the auxiliary layers 184 and 185 may be omitted.

The light emitting elements 20a, 20b, and 20c disposed in the subpixels PX₁, PX₂, and PX₃, respectively, may be the same or different from each other. The light emitting elements 20a, 20b, and 20c disposed in the subpixels PX₁, PX₂, and PX₃, respectively, may emit light of the same emission spectrum, for example, each may emit light of a blue emission spectrum, for example, light of a blue emission spectrum having a maximum emission wavelength in a wavelength region of greater than or equal to about 400 nm and less than about 500 nm, about 410 nm to about 490 nm, about 420 nm to about 480 nm, or about 430 nm to about 470 nm. The light emitting elements 20a, 20b, and 20c disposed in the subpixels PX₁, PX₂, and PX₃, respectively, may or may not be separated by a pixel defining layer (not shown).

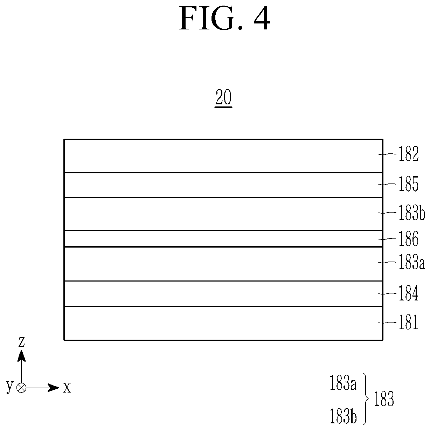

Referring to FIG. 4, the light emitting element 20 may be a light emitting element having a tandem structure, and includes a first electrode 181 and a second electrode 182 facing each other; a first light emitting layer 183a and a second light emitting layer 183b between the first electrode 181 and second electrode 182; a charge generation layer 186 between the first light emitting layer 183a and the second light emitting layer 183b, and optionally auxiliary layers 184 and 185 between the first electrode 181 and the first light emitting layer 183a and between the second electrode 182 and the second light emitting layer 183b.

The first electrode 181, the second electrode 182, and the auxiliary layers 184 and 185 are as described above.

The first light emitting layer 183a and the second light emitting layer 183b may emit light having the same or different emission spectrum, and, for example, each may emit light having a blue emission spectrum. Detailed descriptions are the same as the light emitting layer 183 described above.

The charge generation layer 186 may inject electric charges into the first light emitting layer 183a and/or the second light emitting layer 183b, and may control a charge balance between the first light emitting layer 183a and the second light emitting layer 183b. The charge generation layer 186 may include, for example, an n-type layer and a p-type layer, and may include, for example, an electron transport material and/or a hole transport material including an n-type dopant and/or a p-type dopant. The charge generation layer 186 may be one layer or two or more layers.

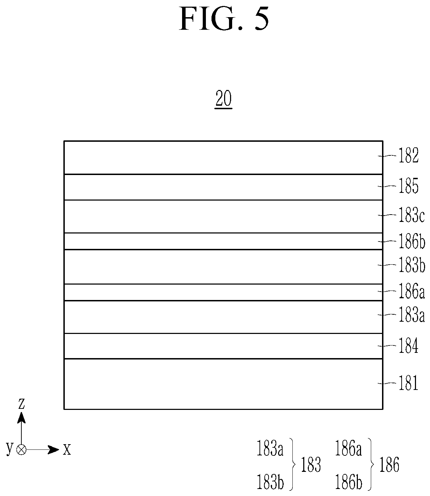

Referring to FIG. 5, the light emitting element 20 may be a light emitting element having a tandem structure, and includes a first electrode 181 and a second electrode 182 facing each other; a first light emitting layer 183a, a second light emitting layer 183b, and a third light emitting layer 183c between the first electrode 181 and the second electrode 182; a first charge generation layer 186a between the first light emitting layer 183a and the second light emitting layer 183b; a second charge generation layer 186b between the second light emitting layer 183b and the third light emitting layer 183c; and optionally auxiliary layers 184 and 185 between the first electrode 181 and the first light emitting layer 183a and between the second electrode 182 and the third light emitting layer 183c.

The first electrode 181, the second electrode 182, and the auxiliary layers 184 and 185 are as described above.

The first light emitting layer 183a, the second light emitting layer 183b, and the third light emitting layer 183c may emit light having the same or different emission spectrum, and, for example, each may emit light having a blue emission spectrum. Detailed descriptions are the same as the light emitting layer 183 described above.

The first charge generation layer 186a may inject electric charges into the first light emitting layer 183a and/or the second light emitting layer 183b, and may control charge balances between the first light emitting layer 183a and the second light emitting layer 183b. The second charge generation layer 186b may inject electric charges into the second light emitting layer 183b and/or the third light emitting layer 183c, and may control charge balances between the second light emitting layer 183b and the third light emitting layer 183c. Each of the first and second charge generation layers 186a and 186b may be one layer or two or more layers.

In an embodiment, the light emitting elements 20a, 20b, and 20c may be micro light emitting diodes (hereinafter, also referred to as "µLEDs"). In this case, a pitch between adjacent light emitting elements, that is, a distance between each center of two adjacent light emitting elements may be less than or equal to about 100 micrometers.

In an embodiment, a central wavelength of light emitted from the light emitting elements 20a, 20b, and 20c may be about 430 nm to about 470 nm, for example, about 440 nm to about 460 nm, but is not limited thereto.

The plurality of light emitting elements 20a, 20b, and 20c may be electrically connected to each other. For example, a plurality of light emitting elements present in subpixels displaying the same color may be electrically connected to each other. As will be described later, lights displayed by the subpixels PX₁, PX₂, and PX₃ are the lights having specific emission spectrums, which are converted by the color conversion layers 30R, 30G, and 30B disposed on the light emitting elements 20a, 20b, and 20c that emit lights having the emission spectrums, respectively, where the color conversion layers 30R, 30G, and 30B convert the lights emitted by the light emitting elements 20a, 20b, and 20c to the different specific emission spectrums from each other. Accordingly, a plurality of light emitting elements under the color conversion layers that convert light emitted from the light emitting elements 20a, 20b, and 20c into light having the same different specific emission spectrum may be electrically connected to each other. For example, plurality of light emitting elements 20a under the color conversion layers 30R that convert blue light emitted from the plurality of light emitting elements 20a, 20b, and 20c into red light may be electrically connected to each other. Also, for example, plurality of light emitting elements 20b under the color conversion layers 30G configured to convert blue light emitted from the plurality of light emitting elements 20a, 20b, and 20c into green light may be electrically connected to each other. Furthermore, plurality of light emitting elements 20c under the color conversion layer 30B that transmits the blue light emitted from the plurality of light emitting elements 20a, 20b, and 20c as it is without converting it into light of a different wavelength may be electrically connected to each other (See the definition of the light transmission layer below). Through these connections, the light emitting elements in the region that emits light of the same color may simultaneously be driven. Accordingly, as will be described later, in fabricating a display panel according to an embodiment, in order to form a color conversion layer having a specific emission spectrum and/or an absorption-type color filter layer formed thereon, light emitting elements under the color conversion layer and the absorption-type color filter layer may selectively be driven at the same time.

As shown in FIG. 2, each of the color conversion layers 30R, 30G, and 30B is formed directly on the corresponding one of the light emitting elements 20a, 20b, and 20c, and for example, may be formed directly on the upper electrode of each of the light emitting elements 20a, 20b, and 20c.

As shown in FIG. 2, each of the color conversion layers 30R, 30G, and 30B is overlapped with the corresponding one of the light emitting elements 20a, 20b, and 20c. Specifically, the color conversion layer 30R is overlapped with the light emitting element 20a, the color conversion layer 30G is overlapped with the light emitting element 20b, and the color conversion layer 30B is overlapped with the light emitting element 20c.

Herein, the "overlapped" means that when the display panel is viewed from the top (i.e., a plan view: a view in a z-direction), the color conversion layer and the light emitting element which are overlapped are present substantially at the same location. In other words, as shown in FIG. 2, when the display panel is viewed (e.g., view in y-direction) from the cross-section cut in a thickness direction, each of the color conversion layers 30R, 30G, and 30B is present on the corresponding one of the light emitting elements 20a, 20b, and 20c, but when display panel is viewed from the top, that is, as shown in FIG. 1, on the plane of the display panel (i.e., a plan view), a location of each of the color conversion layers 30R, 30G, and 30B and a location of the corresponding one of the light emitting elements 20a, 20b, and 20c overlapped with each other or a region taken by each of the color conversion layers 30R, 30G, and 30B and the corresponding one of the light emitting elements 20a, 20b, and 20c overlapped with each other is substantially equivalent. Herein, the "substantially equivalent" means that either one of the light emitting element and the color conversion layer overlapped with each other may have a slightly larger or smaller region than or a partially different outline from the other one of the light emitting element and the color conversion layer overlapped with each other, but the two are mostly the same. However, either one of the overlapped two does not invade the nonoverlapped region of the other one. For example, a specific color conversion layer overlapped with a specific light emitting element among the plurality of color conversion layers formed on the plurality of light emitting elements does not extend to a region where the other light emitting elements excluding the specific light emitting element are present.

In an embodiment, each of the color conversion layers 30R, 30G, and 30B has the same planar size and shape as the corresponding one of the light emitting elements 20a, 20b, and 20c in a plan view.

In another embodiment, on the premise that each of the color conversion layers 30R, 30G, and 30B is overlapped with the corresponding one of the light emitting elements 20a, 20b, and 20c, each of the light emitting elements 20a, 20b, and 20c may have a larger planar size than the corresponding one of the color conversion layers 30a, 30b, and 30c in a plan view.

Each of the color conversion layers 30R and 30G includes quantum dots 121R or 121G for converting light of emission spectra emitted from each of the light emitting elements 20a and 20b into light of different emission spectra. The quantum dots 121R and 121G may convert emission spectra of light emitted from the light emitting elements 20a and 20b into emission spectra of color light displayed by each of subpixels PX₁ and PX₂.

The quantum dot may have a photoluminescence characteristic of receiving light of a predetermined emission spectrum and emitting light of a longer wavelength spectrum. Since the quantum dot has isotropic light emission characteristics, it may emit light in all directions, thereby exhibiting an improved optical viewing angle.

The quantum dot may have various shapes, such as, for example, a spherical shape, a pyramidal shape, a multi-arm shape, a cubic shape, a quantum rod, and a quantum plate. The quantum dot, for example, may have a particle diameter of about 1 nm to about 100 nm (the size of the longest portion if not spherical), and for example, may have a particle diameter of about 1 nm to about 80 nm, for example about 1 nm to about 50 nm, or for example, about 1 nm to about 20 nm.

The quantum dot may control an energy bandgap according to the size and/or composition thereof, and thus the emission wavelength may also be adjusted. For example, as the size of the quantum dot increases, it may have a narrow energy bandgap, and thus may emit light of a relatively long wavelength spectrum. As the size of the quantum dot decreases, the energy bandgap becomes wider, and thus the quantum dots may emit light of a relatively short wavelength spectrum.

For example, according to a size and/or composition thereof, the quantum dot may emit light of, for example, a predetermined wavelength spectrum among the visible light wavelength spectrum. For example, the quantum dot may selectively emit light in one of a red emission spectrum, a green emission spectrum, and a blue emission spectrum. The light in the red emission spectrum may have a maximum emission wavelength, for example, in about 610 nm to about 670 nm, the light of the green emission spectrum may have a maximum emission wavelength, for example, in about 520 nm to about 560 nm, and the light in the blue emission spectrum may have a maximum emission wavelength, for example, in about 420 nm to about 480 nm. For example, light having a plurality of wavelength spectra may be emitted by including two or more types of quantum dots of different sizes and/or compositions. For example, two or more types of quantum dots of different sizes and/or compositions may be mixed or stacked to emit white light.

The quantum dot may have a relatively narrow full width at half maximum ("FWHM"). Herein, the full width at half maximum is the width of a wavelength corresponding to half of the maximum emission point, and when the full width at half maximum is small, light in a narrow wavelength region may be emitted, which indicates high color purity. The quantum dot may have, for example, a full width at half maximum of less than or equal to about 50 nm, and within the above range, for example, less than or equal to about 45 nm, less than or equal to about 40 nm, less than or equal to about 35 nm, less than or equal to about 30 nm, or less than or equal to about 28 nm, within the above range, about 3 nm to about 50 nm, about 3 nm to about 45 nm, about 3 nm to about 40 nm, about 3 nm to about 35 nm, about 3 nm to about 30 nm, or about 3 nm to about 28 nm. As described above, the quantum dot may implement good color purity and color reproducibility by having a relatively narrow full width at half maximum.

The quantum dot may be commercially available or may be synthesized by any method. For example, it may be synthesized by a wet chemical process, metal organic chemical vapor deposition ("MOCVD"), molecular beam epitaxy ("MBE"), or a similar process thereto. In an embodiment, the quantum dots may be colloidal particles synthesized through a wet chemical process. In the wet chemical process, crystal particles are grown by reacting precursor materials in an organic solvent, and in this case, the organic solvent or ligand compound may be coordinated to the surface of the quantum dot, thereby controlling a growth of the crystal. Specific types of organic solvents and ligand compounds are known. The colloidal quantum dots synthesized in the wet chemical process may be recovered by adding a non-solvent to the reaction solution and centrifuging the final mixture. This recovery process may result in the removal of at least a portion of the organic matter coordinated to the surface of the quantum dot. Examples of non-solvents include, but are not limited to, acetone, ethanol, methanol, or the like.

For example, the quantum dot may include a Group II-VI semiconductor compound, a Group III-V semiconductor compound, a Group III-VI semiconductor compound, a Group IV-VI semiconductor compound, a Group IV element or semiconductor compound, a Group I-III-VI semiconductor compound, a Group I-II-IV-VI semiconductor compound, a Group II-III-V semiconductor compound, or a combination thereof.

The Group II-VI semiconductor compound may include, for example, a binary semiconductor compound selected from CdS, CdSe, CdTe, ZnS, ZnSe, ZnTe, ZnO, HgS, HgSe, HgTe, MgSe, MgS, and a mixture thereof; a ternary semiconductor compound selected from CdSeS, CdSeTe, CdSTe, ZnSeS, ZnSeTe, ZnSTe, HgSeS, HgSeTe, HgSTe, HgZnS, HgZnSe, HgZnTe, MgZnSe, MgZnS, CdZnS, CdZnSe, CdZnTe, CdHgSe, CdHgS, CdHgTe, and a mixture thereof; a quaternary semiconductor compound selected from CdZnSeS, CdZnSeTe, CdZnSTe, CdHgSeS, CdHgSeTe, CdHgSTe, HgZnTeS, HgZnSeS, HgZnSeTe, HgZnSTe, and a mixture thereof; or a combination thereof, but is not limited thereto.

The Group III-V semiconductor compound may include, for example, a binary semiconductor compound selected from GaN, GaP, GaAs, GaSb, AIN, AIP, AlAs, AlSb, InN, InP, InAs, InSb, and a mixture thereof; a ternary semiconductor compound selected from GaNP, GaNAs, GaNSb, GaPAs, GaPSb, AINP, AINAs, AINSb, AlPAs, AlPSb, InGaP, InNP, InAlP, InNAs, InNSb, InPAs, InPSb, and a mixture thereof; a quaternary semiconductor compound selected from GaAlNP, GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs, InAlPSb, and a mixture thereof; or a combination thereof, but is not limited thereto. The Group III-V semiconductor compound may further include a Group II element. The Group III-V semiconductor compound further including a Group II element may include, for example, InZnP, InGaZnP, InAIZnP, or a combination thereof.

The Group III-VI semiconductor compound may include, for example, a binary semiconductor compound selected from GaS, GaSe, Ga₂Se₃, GaTe, InS, InSe, In₂Se₃, InTe, and a mixture thereof; a ternary semiconductor compound selected from InGaS₃, InGaSe₃, and a mixture thereof; or a combination thereof.

The Group IV-VI semiconductor compound may include, for example, a binary semiconductor compound selected from SnS, SnSe, SnTe, PbS, PbSe, PbTe, and a mixture thereof; a ternary semiconductor compound selected from SnSeS, SnSeTe, SnSTe, PbSeS, PbSeTe, PbSTe, SnPbS, SnPbSe, SnPbTe, and a mixture thereof; a quaternary semiconductor compound selected from SnPbSSe, SnPbSeTe, SnPbSTe, and a mixture thereof; or a combination thereof, but is not limited thereto.

The Group IV element or semiconductor compound may include, for example, a single element semiconductor selected from Si, Ge, and a mixture thereof; a binary semiconductor compound selected from SiC, SiGe, and a mixture thereof; or a combination thereof, but is not limited thereto.

The Group I-III-VI semiconductor compound may be, for example, AgInS, AgInS₂, CuInS, CuInS₂, CuInSe₂, CuInGaSe, CuInGaS, CuGaO₂, AgGaO₂, AgAlO₂, or a mixture thereof, but is not limited thereto.

The Group I-II-IV-VI semiconductor compound may be, for example, CuZnSnSe, CuZnSnS, or a combination thereof, but is not limited thereto.

The Group II-III-V semiconductor compound may include, for example, InZnP, but is not limited thereto.

The quantum dot may include a binary semiconductor compound, a ternary semiconductor compound, or a quaternary semiconductor compound in a substantially uniform concentration, or may include it in a state in which the concentration distribution is partially different.

For example, the quantum dot may be a semiconductor compound including at least one of indium (In) and zinc (Zn), and phosphorus (P), for example, an In-P semiconductor compound, and/or an In-Zn-P semiconductor compound. For example, the quantum dot may be a semiconductor compound including zinc (Zn), and at least one of tellurium (Te) and selenium (Se), for example, a Zn-Te semiconductor compound, a Zn-Se semiconductor compound, and/or a Zn-Te-Se semiconductor compound.

The quantum dot may have a single structure in which the concentration of each element included in the quantum dot is uniform, or may have a core-shell structure. The shell of the quantum dot may be, for example, a protective layer for preventing chemical modification of the quantum dot core, or a charging layer for imparting electrophoretic properties to the quantum dot.

The shell of the quantum dot may include, for example, a metal or non-metal oxide, a semiconductor compound, or a combination thereof. Examples of metal or non-metal oxides may include a binary compound selected from SiO₂, Al₂O₃, TiO₂, ZnO, MnO, Mn₂O₃, Mn₃O₄, CuO, FeO, Fe₂O₃, Fe₃O₄, CoO, Co₃O₄, NiO, and a mixture thereof; a ternary compound selected from MgAl₂O₄, CoFe₂O₄, NiFe₂O₄, CoMn₂O₄, and a mixture thereof; or a combination thereof. Examples of the semiconductor compound may include the aforementioned Group II-VI semiconductor compound, Group III-V semiconductor compound, Group III-VI semiconductor compound, Group IV-VI semiconductor compound, Group IV element or semiconductor compound, Group I-III-VI semiconductor compound, Group I-II-IV-VI semiconductor compound, Group II-III-V semiconductor compound, or a combination thereof, for example, CdS, CdSe, CdTe, ZnS, ZnSe, ZnTe, ZnSeS, ZnTeS , GaAs, GaP, GaSb, HgS, HgSe, HgTe, InAs, InP, InGaP, InSb, AlAs, AIP, AlSb, or a combination thereof.

For example, the interface between the core and the shell of the quantum dot may have a concentration gradient in which a concentration of the element in the shell decreases toward the center. For example, the material composition constituting the shell of the quantum dot may have a higher energy bandgap than the material composition constituting the core of the quantum dot, and thus the quantum dot may have a quantum confinement effect. The quantum dot may include one quantum dot core and a multi-layered quantum dot shell surrounding it. In this case, the multi-layered shell may have two or more layers, and each layer may independently have a single composition, an alloy, and/or concentration gradient. For example, among the multi-layered shells, a shell farther from the core may have a higher energy bandgap than a shell close to the core, and thus the quantum dot may have a quantum confinement effect.

For example, the quantum dot may include a cadmium-free quantum dot (Cd-free quantum dot). The cadmium-free quantum dot is a quantum dot that does not contain cadmium (Cd). Since cadmium (Cd) may cause serious environmental/health problems and is a regulated element under the Restriction of Hazardous Substances ("RoHS") in many countries, the quantum dot may be effectively used.

The quantum dot may have an organic ligand bound to its surface. The organic ligand may have a hydrophobic moiety. The organic ligand may include RCOOH, RNH₂, R₂NH, R₃N, RSH, R₃PO, R₃P, ROH, RCOOR', RPO(OH)₂, R₂POOH (where, R and R' are independently hydrogen, a C1 to C30 substituted or unsubstituted aliphatic hydrocarbon group, for example a C1 to C30 alkyl group, a C2 to C30 alkenyl group, or a C6 to C30 aromatic hydrocarbon group, for example a C6 to C20 aryl group, provided that at least one is not hydrogen), or a combination thereof.

Specific examples of the organic ligand may include thiol compounds such as methane thiol, ethane thiol, propane thiol, butane thiol, pentane thiol, hexane thiol, octane thiol, dodecane thiol, hexadecane thiol, octadecane thiol, benzyl thiol, or the like; amines such as methane amine, ethane amine, propane amine, butane amine, pentyl amine, hexyl amine, octyl amine, nonylamine, decylamine, dodecyl amine, hexadecyl amine, octadecyl amine, dimethyl amine, diethyl amine, dipropyl amine, tributylamine, trioctylamine, or the like; carboxylic acid compounds such as methanoic acid, ethanoic acid, propanoic acid, butanoic acid, pentanoic acid, hexanoic acid, heptanoic acid, octanoic acid, dodecanoic acid, hexadecanoic acid, octadecanoic acid, oleic acid, benzoic acid, or the like; phosphine compounds such as methyl phosphine, ethyl phosphine, propyl phosphine, butyl phosphine, pentyl phosphine, octylphosphine, dioctyl phosphine, tributylphosphine, trioctylphosphine, or the like; phosphine compounds or oxide compounds thereof such as methyl phosphine oxide, ethyl phosphine oxide, propyl phosphine oxide, butyl phosphine oxide pentyl phosphineoxide, tributylphosphineoxide, octylphosphine oxide, dioctyl phosphineoxide, and trioctylphosphineoxide; diphenyl phosphine, triphenyl phosphine compounds or oxide compounds thereof; (mono- or di) C5 to C20 alkylphosphinic acid such as (mono- or di) hexylphosphinic acid, (mono- or di) octylphosphinic acid, (mono- or di) dodecanephosphinic acid, (mono- or di) tetradecanephosphinic acid, (mono- or di) hexadecanephosphinic acid, and (mono- or di) octadecanephosphinic acid, C5 to C20 alkyl phosphonic acid such as hexylphosphonic acid, octylphosphonic acid, dodecanephosphonic acid, tetradecanephosphonic acid, hexadecanephosphonic acid, and octadecanephosphonic acid, but are not limited thereto. The organic ligand may be used alone or as a mixture of two or more.

Each of the color conversion layers 30R, 30G, and 30B may further include a phosphor (not shown). Examples of the phosphor may include, for example, (Ca, Sr, Ba)S, (Ca, Sr, Ba)₂Si₅N₈, CaAlSiN₃, CaMoO₄, or Eu₂Si₅N₈ as a red phosphor, yttrium aluminum garnet (YAG), (Ca, Sr, Ba)₂SiO₄, SrGa₂S₄, barium magnesium aluminate (BAM), alpha SiAlON(α-SiAlON), beta SiAION (β-SiAlON), Ca₃Sc₂Si₃O₁₂, Tb₃Al₅O₁₂, BaSiO₄, CaAISiON, or (Sr₁₋ₓBaₓ)Si₂O₂N₂ (wherein x may be any number between 0 and 1) as a green phosphor, but are not limited thereto.

Each of the color conversion layers 30R, 30G, and 30B may emit light of a wavelength spectrum of a color displayed by the corresponding one of the subpixels PX1, PX2, and PX3, and accordingly, the quantum dots 121R and 121G included in the color conversion layers 30R and 30G, respectively, may be different from each other.

For example, the quantum dots 121R included in the color conversion layer 30R may convert the light emitted from the light emitting element 20a into light having a first emission spectrum that is the same as the wavelength spectrum of the color displayed in the first subpixel PX₁. The first emission spectrum may be different from the emission spectrum of the light emitted from the light emitting element 20a, and may be a longer wavelength spectrum. Accordingly, the display panel according to an embodiment may include a first color conversion layer 30R including quantum dots 121R that convert an emission spectrum of light emitted from the light emitting element 20a among a plurality of color conversion layers into the first emission spectrum.

In addition, for example, the quantum dots 121G included in the color conversion layer 30G may convert the light emitted from the light emitting element 20b into light having a second emission spectrum that is the same as the wavelength spectrum of the color displayed in the second subpixel PX₂. The second emission spectrum may be different from the first emission spectrum and the emission spectrum of the light emitted from the light emitting element 20b, and may be a wavelength spectrum longer than the emission spectra of light emitted from the light emitting element 20b and shorter than the first emission spectrum. Accordingly, the display panel according to an embodiment may include a second color conversion layer 30G including quantum dots 121G that convert an emission spectrum of light emitted from the light emitting element 20b among a plurality of color conversion layers into a second emission spectrum.

For example, each of the plurality of light emitting elements 20a, 20b, and 20c may emit light having a blue emission spectrum, and when the first subpixel PX₁, second subpixel PX₂, and third subpixel PX₃ display red, green, and blue colors, respectively, the first color conversion layer 30R of the first subpixel PX₁ may include red light emitting quantum dots 121R that convert light of a blue emission spectrum into light of a red emission spectrum, and the second color conversion layer 30G of the second subpixel PX₂ may include green light emitting quantum dots 121G that convert light of a blue emission spectrum into light of a green emission spectrum. Since the blue color displayed in the third subpixel PX₃ may be displayed by the light of the blue emission spectrum emitted from the light emitting element 20c, the third color conversion layer 30B of the third subpixel PX₃ may not include a color converter, for example, quantum dots. In this case, the third color conversion layer 30B may also be referred to as a "light transmission layer". However, in another embodiment, the third color conversion layer 30B may further include a color converter such as quantum dots for emitting light of a blue emission spectrum, or a pigment or dye. In this case, the third color conversion layer 30B including the quantum dot, pigment, or dye may reduce external light reflection and provide blue light with improved color purity.

At least one of the color conversion layers 30R, 30G, and 30B may further include a scatterer (not shown). When each of the color conversion layers 30R, 30G, and 30B includes a scatterer, a content of the scatterer may be different. The scatterer may scatter and/or reflect light in multiple directions irrespective of the angle of incidence without substantially changing the wavelength of light emitted from the quantum dots and/or light emitting elements 20a, 20b, and 20c, and thus the amount of light that is converted or passed through the color conversion layers 30R, 30G, and 30B may increase, and front luminance and side luminance of the color conversion layers may be uniformly provided.

The scatterer may be a low refractive index nanoparticle, for example, a metal or a semi-metal oxide such as silicon oxide, titanium oxide, zirconium oxide, aluminum oxide, indium oxide, zinc oxide, tin oxide, or a combination thereof; an organic material such as an acrylic resin, a urethane resin, or a combination thereof; or a combination thereof, but is not limited thereto.

In an embodiment, the color conversion layers 30R and 30G may include quantum dots 121R and 121G dispersed in a polymer matrix. The polymer matrix may include a light transmitting resin. The light transmitting resin may be a dispersion medium for dispersing quantum dots and/or scattering particles, for example, an acrylic resin, a urethane resin, a silicone resin, an epoxy resin, a cardo-based resin, an imide resin, a derivative thereof, or a combination thereof, but is not limited thereto. The light transmitting resin may be prepared from a photosensitive resin composition including a photopolymerizable monomer, a polymer including a photosensitive functional group, or a combination thereof.

The photosensitive resin composition may further include a photo initiator that helps the photopolymerizable monomer, polymer, or a combination thereof to undergo a polymerization reaction by exposure to light. In an embodiment, the photo initiator may be a photo initiator that reacts at a central wavelength of light emitted by the light emitting elements 20a, 20b, and 20c. Accordingly, as will be described later, when fabricating a display panel according to an embodiment, the photosensitive resin composition including the photo initiator may have a better photopolymerization reaction by the light emitted from the light emitting elements 20a, 20b, and 20c. The photosensitive resin composition may further include a solvent.

The absorption-type color filter layers 40R, 40G, and 40B are disposed directly on the color conversion layers 30R, 30G, and 30B to be overlapped therewith, respectively. By further including the absorption-type color filter layers 40R, 40G, and 40B on the color conversion layers 30R, 30G, and 30B, color purity of the light emitted from the display panels 1000 and 100 including the color conversion layers 30R, 30G, and 30B according to the embodiment may further increase.

Referring again to FIG. 2, each of the absorption-type color filter layers 40R, 40G, and 40B is overlapped with the corresponding one of the color conversion layers 30R, 30G, and 30B and directly disposed on the corresponding one of the color conversion layers 30R, 30G, and 30B. Referring to FIGS. 1 and 2 together, in the display panels 1000 and 100 according to embodiments, each of the absorption-type color filter layers 40R, 40G, and 40B is formed along the surface shape of the corresponding one of the color conversion layers 30R, 30G, and 30B by being directly disposed on the corresponding one of the color conversion layers 30R, 30G, and 30B. As described above, in the display panels 1000 and 100 according to the embodiments, the absorption-type color filter layers 40R, 40G, and 40B are formed directly on the color conversion layers 30R, 30G, and 30B, respectively, without an additional layer such as a planarization layer therebetween.

The absorption-type color filter layers 40R, 40G, and 40B are disposed in a direction in which light passing through the color conversion layers 30R, 30G, and 30B is emitted. Each of the absorption-type color filter layers 40R, 40G, and 40B may selectively transmit light of the same wavelength spectrum as the color displayed by the corresponding one of the subpixels PX₁, PX₂, and PX₃, and may selectively transmit the light of the emission spectrum of the light obtained by converting the emission spectrum of the light emitted from the corresponding one of the light emitting elements 20a, 20b, and 20c by the corresponding one of the color conversion layers 30R, 30G, and 30B.

For example, when the first subpixel PX₁, the second subpixel PX₂, and the third subpixel PX₃ display red, green, and blue colors, respectively, and light of a red emission spectrum, a green emission spectrum, and a blue emission spectrum is emitted from the first color conversion layer 30R, the second color conversion layer 30G, and the light transmission layer 30B, respectively, the first absorption-type color filter layer 40R overlapped with the first color conversion layer 30R may be a red filter layer, the second absorption-type color filter layer 40G overlapped with the second color conversion layer 30G may be a green filter layer, and the third absorption-type color filter layer 40B overlapped with the light transmission layer 30B may be a blue filter layer. The first absorption-type color filter layer 40R, the second absorption-type color filter layer 40G, and the third absorption-type color filter layer 40B respectively may include a pigment or dye that selectively transmits light in the red wavelength spectrum, the green wavelength spectrum, or the blue wavelength spectrum, and absorbs and/or reflects light of the rest of the wavelength spectrum.

The absorption-type color filter layers 40R, 40G, and 40B may more precisely filter and emit light emitted from the color conversion layers 30R, 30G, and 30B, thereby increasing the color purity of the light. For example, the first absorption-type color filter layer 40R overlapped with the first color conversion layer 30R blocks light that is not converted into red light by the first quantum dots 121R in the first color conversion layer 30R, but is transmitted as it is and thereby increasing the color purity of light in the red emission spectrum. For example, the second absorption-type color filter layer 40G overlapped with the second color conversion layer 30G blocks light that is not converted into green light by the second quantum dots 121G in the second color conversion layer 30G, and is transmitted as it is, thereby increasing the color purity of light in the green emission spectrum. For example, the third absorption-type color filter layer 40B overlapped with the light transmission layer 30B blocks light other than light in the blue emission spectrum, thereby increasing the color purity of light in the blue emission spectrum. In an embodiment, at least some of the first, second, and third absorption-type color filter layers 40R, 40G, and 40B may be omitted, and for example, the third absorption-type color filter layer 40B overlapped with the light transmission layer 30B may be omitted.

In general, a display device such as a display including a self-emission type color conversion layer such as a quantum dot or the like is manufactured by stacking an absorption-type color filter layer with a quantum dot color conversion layer in order to secure high color purity due to limitation of an absorption rate of the quantum dots. Herein, the display is manufactured by sequentially stacking a color-separating partition wall or a light blocking layer, the absorption-type color filter layer, and the quantum dot color conversion layer on an upper glass substrate due to issues such as film uniformity, processability, or the like, and then, bonding the upper glass substrate with a lower glass substrate having a light emitting element by using an optical clear adhesive ("OCA") film or the like. In addition, in the process of manufacturing the upper glass substrate including the absorption-type color filter layer and the color conversion layer, about 6 or more photo-etching processes on average are required to form each layer including an aligner and a photomask. Such a complicated process may affect a unit price of the display, increase a thickness and a weight of the display, and also, crack or peel off an adhesive layer between upper glass substrate and lower glass substrate due to heat generated during the operation.

The present inventors have proposed, as an innovative method to improve the aforementioned problems in the prior art (Korean Patent Application No. 10-2018-0164051), a method of fabricating a display panel including no separate adhesive layer between the light emitting element and the color conversion layer including a quantum dot in a bottom exposure method using light from the light emitting element itself constituting the display panel rather than an upper exposure method of using a conventional external light source, and a display panel having the color conversion layer including a quantum dot directly on the light emitting element fabricated in this method

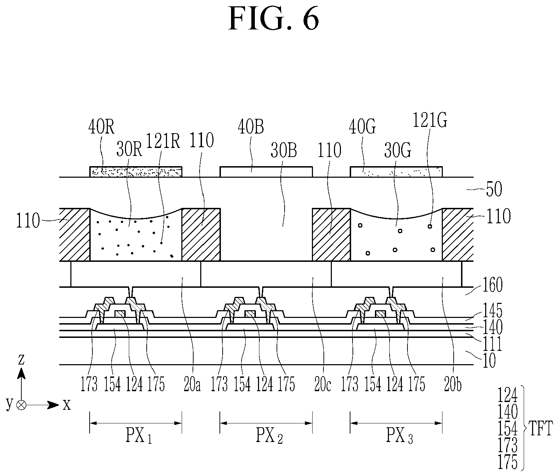

In such a display panel, each color conversion layer including a quantum dot is overlapped with each light emitting element and present directly on the light emitting element, as equally in the display panel according to the aforementioned embodiment. However, even in the display panel, the absorption-type color filter layer is difficult to form directly on the color conversion layer including a quantum dot and to directly contact the color conversion layer without including an additional layer such as a planarization layer or the like between the color conversion layer including a quantum dot and the absorption-type color filter layer. The reason is that when the color conversion layer including quantum dots is formed on the light emitting element, the color conversion layer may hardly be formed to have a structurally flat upper surface through development and thermal processes after the exposure, and accordingly, the absorption-type color filter layer, which is relatively thin, for example, about 3 micrometer thick, compared with the color conversion layer including quantum dots, is difficult to uniformly form on the color conversion layer with a non-uniform surface. Accordingly, even in the display panel according to a prior art belonging to the inventors, before forming the absorption-type color filter layer on the color conversion layer including quantum dots, an overcoat layer is first coated for planarization (refer to FIG. 6). Specifically, as shown in FIG. 6, an additional layer such as an adhesive layer or a planarization layer is not present between the quantum dot color conversion layers 30R, 30G, and 30B and the light emitting elements 20a, 20b, and 20c, but the overcoat layer 50 is present between the quantum dot color conversion layer 30R, 30B, and 30G and the absorption-type color filter layers 40R, 40G, and 40B. When the absorption-type color filter layer is formed in a photolithography method with upper exposure by using a photomask without this overcoat layer 50, the absorption-type color filter layer may have no uniform thickness and various luminance in each pixel, which may cause a severe problem in driving the display device.

However, as shown in FIG. 2, in the display panel according to an embodiment, there is no additional layers between the group of the color conversion layers 30R, 30G, and 30B including quantum dots and the group of the absorption-type color filter layers 40R, 40G, and 40B. The display panel according to the embodiment does not include an adhesive layer for bonding the lower glass substrate including the light emitting element to the upper glass substrate including the self-emission type color conversion layer and the absorption-type color filter layer in the conventional display panel, and also does not include any additional layer between the color conversion layer including quantum dots and the absorption-type color filter layer. Accordingly, the display panel according to the embodiment becomes thinner and lighter than the conventional display panel, and because it does not include the aforementioned overcoat layer or planarization layer, loss of light passing therethrough is reduced, and thus light efficiency is also improved. In addition, the display panel has a simple fabricating process, as will be described later, and accordingly, fabricating time and cost may be significantly reduced. A method of fabricating the display panel according to the embodiment will be described in more detail below.

The absorption-type color filter layers 40R, 40G, and 40B may include a pigment, a dye, or a combination thereof for manufacturing the absorption-type color filter, and in an embodiment, the pigment, the dye, or a combination thereof may be included in a dispersed form in the polymer matrix. The polymer matrix may include the same light transmitting resin as the light transmitting resin included in the color conversion layers 30R, 30G, and 30B. That is, the absorption-type color filter layer may also be manufactured from the photosensitive resin composition. The photosensitive resin composition may include a photopolymerizable monomer, a polymer, or a combination thereof, a photo initiator, and/or a solvent which are similar to the photosensitive resin composition for manufacturing the color conversion layers 30R, 30G, and 30B and may further include a pigment, a dye, or a combination thereof that may be used for manufacturing the absorption-type color filter layers. The pigment and dye included in the absorption-type color filter layer may be known pigments and dyes. As described above, the photo initiator may be a photo initiator that reacts at a central wavelength of light emitted from the light emitting elements 20a, 20b, and 20c. Accordingly, as will be described later, when fabricating a display panel according to an embodiment, the photosensitive resin composition including the photo initiator may more easily undergo a photopolymerization reaction by the light emitted from the light emitting elements 20a, 20b, and 20c.

As shown in FIG. 2, partition walls 110 are disposed between the plurality of the color conversion layers 30R, 30G, and 30B. The partition walls 110 may have a grid shape extending along the x-direction and the y-direction of the display panels 1000 and 100. Specifically, the partition walls 110 are disposed between the first color conversion layer 30R and the second color conversion layer 30G, between the second color conversion layer 30G and the light transmission layer 30B, and between the light transmission layer 30B and the first color conversion layer 30R. In addition, the partition walls 110 may also be disposed between two adjacent first color conversion layers 30R, between two adjacent second color conversion layers 30G, and between two adjacent light transmission layers 30B. That is, the partition walls 110 partition each of the plurality of color conversion layers 30R, 30G, and 30B, and serve to prevent color mixing of light emitted from the adjacent color conversion layers 30R, 30G, and 30B. The partition walls 110 may be in direct contact with the color conversion layers 30R, 30G, and 30B, and a separate layer may not be disposed between the partition walls 110 and each of the color conversion layers 30R, 30G, and 30B.

Since the quantum dots may emit light in all directions due to isotropic light emission characteristics, the light emitted from the quantum dots 121R and 121G in each of the color conversion layers 30R and 30G may be spread in all directions. Accordingly, the partition wall 110 present between the color conversion layers 30R, 30G, and 30B may not absorb light emitted from the quantum dots 121R and 121G in the color conversion layers 30R and 30G, but scatter and/or reflect the light into each of the color conversion layers 30R, 30G, and 30B to guide the light emitted from the color conversion layers 30R, 30G, and 30B toward the absorption-type color filter layers 40R, 40G, and 40B each directly present on the corresponding one of the color conversion layers 30R, 30G, and 30B. Due to this role of the partition wall 110, the display panel according to an embodiment has no loss of the light emitted from each of the color conversion layers 30R, 30G, and 30B but emit the light toward each of the absorption-type color filter layers 40R, 40G, and 40B present thereon. Accordingly, light efficiency and color purity of the display panel according to an embodiment may be improved. Likewise, light emitted from each of the light emitting elements 20a, 20b, and 20c also may not be absorbed in the partition wall 110 but scattered and/or reflected by the partition wall 110 and guided toward the color conversion layers 30R, 30G, and 30B directly present on the light emitting elements 20a, 20b, and 20c, thereby improving light efficiency of the display panel according to an embodiment.

In FIG. 2, the partition wall 110 having an equal width is illustrated as an example, but not limited thereto, and a cross-section thereof may have various sizes and shapes. For example, the partition wall 110 may have a trapezoid cross-section, for example, a trapezoid cross-section in which the upper surface has a longer length than the lower surface. Herein, the partition wall 110 may be more advantageous to prevent color mixing among the color conversion layers 30R, 30G, and 30B.

Hereinafter, a method of fabricating a display panel according to an embodiment will be described.

As described above, the present inventors disclosed a display panel having a color conversion layer including a quantum dot disposed directly on a light emitting element fabricated by the bottom exposure method using light from the light emitting element that constitutes the display panel, rather than an upper exposure method of fabricating a display panel, in Korean Patent Application 10 -2018-0164051. The present inventors have solved the problem of requiring a planarization layer or the like between color conversion layer and absorption-type color filter layer to form the absorption-type color filter layer on the color conversion layer including a quantum dot in the display panel and developed a method of forming the absorption-type color filter layer directly on the color conversion layer to directly contact the color conversion layer without an additional layer or the like such as the planarization layer or the like between color conversion layer and absorption-type color filter layer.

Specifically, a method of fabricating a display panel according to an embodiment includes preparing a substrate including a plurality of light emitting elements including a semiconductor light emitting chip, and a first color conversion layer including a first quantum dot disposed on at least one of the plurality of light emitting elements, forming a first photosensitive resin layer including a pigment, a dye, or a combination thereof on the substrate on which the first color conversion layer is formed, and driving the light emitting element on which the first color conversion layer is formed to form a first absorption-type color filter layer in which the first photosensitive resin layer is cured on the first color conversion layer.

In other words, the method of fabricating a display panel according to an embodiment includes forming a photosensitive resin layer for forming an absorption-type color filter layer on a color conversion layer including a quantum dot and directly disposed on a light emitting element, and exposing the photosensitive resin layer for the absorption-type color filter layer to light not converted but leaked by the color conversion layer out of light emitted from the light emitting element, while passing the color conversion layer including the quantum dot, to cure the photosensitive resin layer.

For example, when the light emitting element emits light of a blue emission spectrum, and the color conversion layer includes a quantum dot that converts the blue light emitted from the light emitting element into light with a longer wavelength, for example, light of a red emission spectrum, most of the blue light emitted from the light emitting element is converted into red light in the color conversion layer, but not 100% of the light emitted from the light emitting element is converted into the light of a red emission spectrum due to limitation of the absorption rate of the color conversion layer including the quantum dot. For example, a color conversion layer including a red light-emitting quantum dot converts the light of a blue emission spectrum into red light at a conversion rate of about 90% to about 95%, and transmits and thus leaks about 5% to about 10% of the light of a blue emission spectrum. In addition, for example, a color conversion layer including a green light emitting quantum dot converts about 85% to about 90% of the light of a blue emission spectrum into green light, and transmits and thus leaks the remaining about 10% to about 15% of the light of a blue emission spectrum.

The present inventors have paid attention to a fact that when the light emitted from the light emitting element, for example, the light of a blue emission spectrum, passes the color conversion layer, for example, the color conversion layer including a red light emitting quantum dot, or the color conversion layer including a green light emitting quantum dot, at least about 5% to about 15% of the light of the blue emission spectrum is not converted into light of a red or green emission spectrum, but leaked, and discovered that each absorption-type color filter layer formed on each color conversion layer may be formed by exposing a photosensitive resin layer to the light leaked through each color conversion layer to cure it. According to the present invention, the absorption-type color filter layer may be formed on each color conversion layer without forming any additional layer or requiring surface uniformity of each color conversion layer. The reason is that the absorption-type color filter layer formed on each color conversion layer has a thickness automatically determined up to a point where the blue light passing and leaking from the color conversion layer reaches about 0%. Accordingly, a display panel including the absorption-type color filter layer has an effect of automatically adjusting transmittance of the blue light for a corresponding pixel to about 0%, when fabricated into a display device or the like. Furthermore, including no planarization layer between the color conversion layer and the absorption-type color filter layer may prevent color mixing therethrough, thereby improving light efficiency and color purity.

Hereinafter, a method of fabricating a display panel according to an embodiment will be described in detail with reference to the drawings.

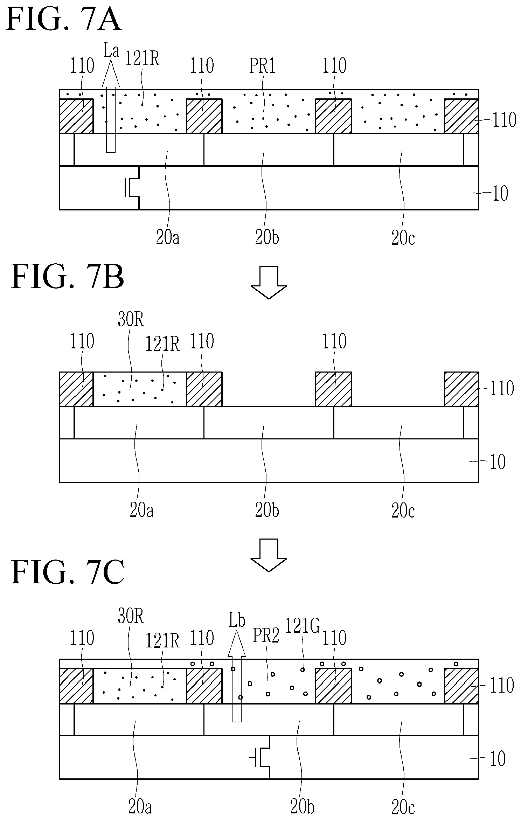

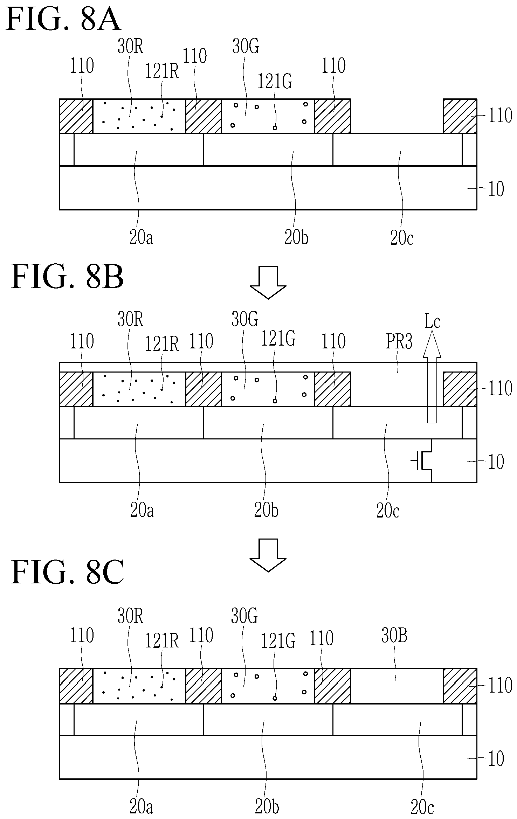

First, referring to FIGS. 7 and 8, a method of forming a color conversion layer including a quantum dot on a light emitting element is illustrated. However, this corresponds to an example of the method according to the prior patent application of the present inventors, but the present invention is not limited thereto. In other words, as any method known to those skilled in the art, all methods of using a substrate in which a color conversion layer including a quantum dot is formed directly on a light emitting element and forming an absorption-type color filter layer along a surface shape of the color conversion layer are included in the method of fabricating a display panel according to an embodiment.

In FIGS. 7 to 10, for convenience, a structure of the light emitting elements 20a, 20b, and 20c, and a structure of a thin film transistor, etc. are not shown in detail and omitted, and only a mark indicating an electrical connection is briefly shown.

First, referring to FIGS. 7 and 8, after forming a first photosensitive resin layer PR1 including a first quantum dot 121R on the partition walls 110 partitioning color conversion layers and on the light emitting elements 20a, 20b, and 20c, the light emitting element 20a is driven to expose a portion of the first photosensitive resin layer PR1 disposed between two partition walls 110 adjacent to the light emitting element 20a to the light La to cure the portion of the first photosensitive resin layer PR1 (refer to FIG. 7A), and then the uncured portion of the photosensitive resin layer PR1 is removed by using a developing solution, such that a first color conversion layer 30R is formed on the light emitting element 20a (refer to FIG. 7B). Subsequently, on the first color conversion layer 30R, the partition walls 110, and the light emitting elements 20b, and 20c, a second photosensitive resin layer PR2 including a second quantum dot 121G is formed, and then the light emitting element 20b is driven to expose a portion of the second photosensitive resin layer PR2 disposed between two partition walls 110 adjacent to the light emitting element 20b to the light Lb to cure the portion of the second photosensitive resin layer PR2 (refer to FIG. 7C). Subsequently, the uncured portion of the photosensitive resin layer PR2 is removed by using a developing solution, such that a second color conversion layer 30G is formed on the light emitting element 20b (refer to FIG. 8A). In addition, on the first color conversion layer 30R, the second color conversion layer 30G, the partition walls 110, and the light emitting element 20c, a third photosensitive resin layer PR3 including no quantum dot is formed, and the light emitting element 20c is driven to expose a portion of the third photosensitive resin layer PR3 disposed between two partition walls 110 adjacent to the light emitting element 20c to the light Lc to cure the portion of the third photosensitive resin layer PR3 (refer to FIG. 8B). The uncured portion of the third photosensitive resin layer PR3 is removed by using a developing solution, and a light transmission layer 30B is formed on the light emitting element 20c (refer to FIG. 8C).

Accordingly, as an example, the substrate 10 on which the first color conversion layer 30R including the first quantum dot 121R, the second color conversion layer 30G including the second quantum dot 121G, and the light transmission layer 30B including no quantum dot are formed on the plurality of light emitting elements 20a, 20b, and 20c, respectively, is obtained.

In FIGS. 7 and 8, a case that the first color conversion layer 30R, the second color conversion layer 30G, and the light transmission layer 30B are formed in this order is illustrated. However, the invention is not limited to this order. Any order of forming the first color conversion layer 30R, the second color conversion layer 30G, and the light transmission layer 30B is possible.

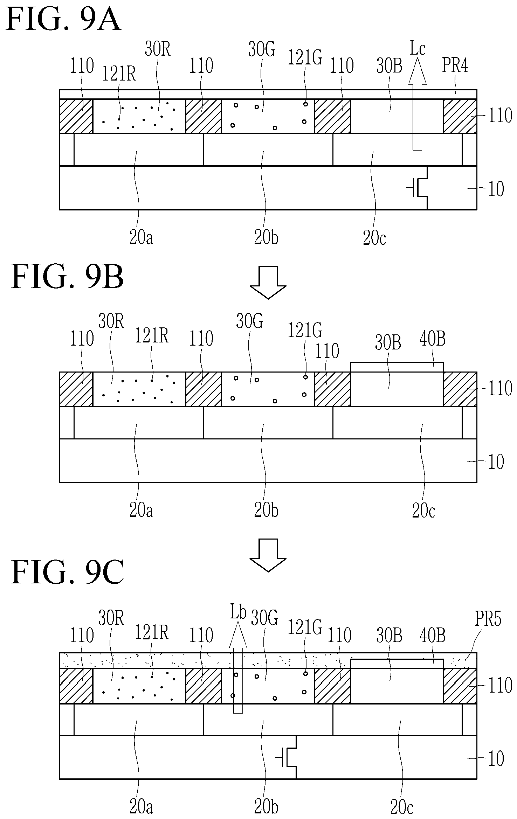

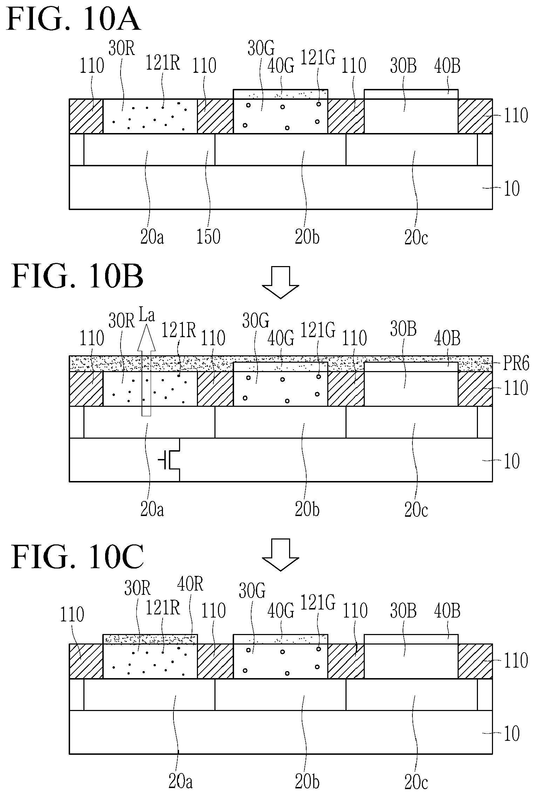

Subsequently, on the substrate 10 on which the first color conversion layer 30R, the second color conversion layer 30G, and the light transmission layer 30B are formed, the first absorption-type color filter layer 40R, the second absorption-type color filter layer 40G, and the third absorption-type color filter layer 40B are formed according to an embodiment. This is illustrated referring to FIGS. 9 and 10.

Referring to FIG. 9, on the first color conversion layer 30R including the first quantum dot 121R, second color conversion layer 30G including the second quantum dot 121G, and light transmission layer 30B including no quantum dot, which are formed on the light emitting elements 20a, 20b, and 20c, respectively, a fourth photosensitive resin layer PR4 for forming a third absorption-type color filter layer 40B is formed, and then the light emitting element 20c on which the light transmission layer 30B is formed is driven (refer to FIG. 9A). Accordingly, the light Lc emitted from the light emitting element 20c, for example, blue light, passes the light transmission layer 30B and reaches a point at which the fourth photosensitive resin layer PR4 is formed, and thus a portion of the fourth photosensitive resin layer PR4 corresponding to the light transmission layer 30B is exposed thereto. Subsequently, the portion of the fourth photosensitive resin layer PR4 is cured, and the uncured portion of the fourth photosensitive resin layer PR4 is removed by using a developing solution, such that the third absorption-type color filter layer 40B is formed on the light transmission layer 30B (refer to FIG. 9B). Subsequently, on the third absorption-type color filter layer 40B, the partition walls 110, the first color conversion layer 30R, and the second color conversion layer 30G, a fifth photosensitive resin layer PR5 for forming a second absorption-type color filter layer 40G is formed, and as shown in FIG. 9C, the light emitting element 20b on which the second color conversion layer 30G is formed is driven to emit blue light. Accordingly, a portion of the fifth photosensitive resin layer PR5 corresponding to the second color conversion layer 30G is exposed to the blue light not converted into green light but leaked through the second color conversion layer 30G, and then, the uncured portion of the fifth photosensitive resin layer PR5 is removed. Therefore, the second absorption-type color filter layer 40G is formed on the second color conversion layer 30G (refer to FIG. 10A). Subsequently, on the third absorption-type color filter layer 40B, the second absorption-type color filter layer 40G, the partition walls 110 and the first color conversion layer 30R, a sixth photosensitive resin layer PR6 for forming a first absorption-type color filter layer 40R is formed, and subsequently, the light emitting element 20a on which the first color conversion layer 30R is formed is driven to emit blue light (refer to FIG. 10B). Accordingly, a portion of the sixth photosensitive resin layer PR6 corresponding to the first color conversion layer 30R is exposed to the blue light not converted into red light but leaked through the first color conversion layer 30R, and then, cured, and the other uncured portion of the sixth photosensitive resin layer PR6 is removed by using a developing solution. Therefore, the first absorption-type color filter layer 40R is formed on the first color conversion layer 30R (refer to FIG. 10C).

In FIGS. 9 and 10, a case that the third absorption-type color filter layer 40B, the second absorption-type color filter layer 40G, and the first absorption-type color filter layer 40R are formed in this order is illustrated. However, the invention is not limited to this order. Any order of forming the first absorption-type color filter layer 40R, the second absorption-type color filter layer 40G, and the third absorption-type color filter layer 40B is possible.

When performed as described above, a display panel including the first absorption-type color filter layer 40R directly formed on the first color conversion layer 30R, the second absorption-type color filter layer 40G directly formed on the second color conversion layer 30G, and the third absorption-type color filter layer 40B directly formed on the light transmission layer 30B, which are disposed on the substrate 10 on which the plurality of light emitting elements 20a, 20b, and 20c and first color conversion layer 30R including the first quantum dot 121R, second color conversion layer 30G including the second quantum dot 121G, and light transmission layer 30B including no quantum dot are disposed, may be obtained.

As described above, in the display panel 100 according to an embodiment, the color conversion layers 30R, 30G, and 30B and the absorption-type color filter layers 40R, 40G, and 40B disposed directly on the color conversion layers 30R, 30G, and 30B, respectively, are fabricated by being exposed to a total amount of light emitted from the light emitting elements 20a, 20b, and 20c respectively, present therebelow, and thus, the color conversion layers and the absorption-type color filter layer formed on the light emitting elements, respectively, may have different thicknesses according to an amount of light and a luminance difference of each light emitting element. On the contrary, in a conventional display panel including a self-emission type color conversion layer and an absorption-type color filter layer, the self-emission type color conversion layers and the absorption-type color filter layers have the same thicknesses with each other as by being fabricated without considering an amount of light emitted from each light emitting element and a luminance difference thereof. Accordingly, the display panel may have an effect of automatically adjusting a light amount and/or a luminance difference of each light emitting element.

As described above, the display panel according to an embodiment may be easily fabricated by sequentially applying each photosensitive resin composition for forming the color conversion layers 30R, 30G, and 30B and/or the absorption-type color filter layers 40R, 40G, and 40B on the substrate 10 in which the plurality of light emitting elements 20a, 20b, and 20c are formed, and selectively driving only a light emitting element in a region for forming each of the color conversion layers 30R, 30G, and 30B and/or absorption-type color filter layers 40R, 40G, and 40B to emit light to easily expose the desired region thereto, cure it, and to easily form each of the color conversion layers 30R, 30G, and 30B and absorption-type color filter layers 40R, 40G, and 40B.

The exposure by the light emitting elements 20a, 20b, and 20c and polymerization of each photosensitive resin composition according thereto may occur in a region where light emitted from each light emitting element reaches, and on the driven light emitting element, the photosensitive resin composition may be cured. Accordingly, even though a photosensitive resin composition for forming a specific color conversion layer or a specific absorption-type color filter layer is applied to the entire substrate, only a light emitting element present in a specific subpixel region may be driven to emit light, so that the specific color conversion layer or the specific absorption-type color filter layer may be formed in the specific subpixel region. Subsequently, the uncured photosensitive resin composition for forming the specific color conversion layer or the specific absorption-type color filter layer in the subpixel region is removed through the development process. Therefore, a pattern of the specific color conversion layer or the specific absorption-type color filter layer is formed only in the specific subpixel region. This process of forming the color conversion layer and the absorption-type color filter layer is repeated as many times as the number of types of color conversion layers having different emission spectra, and each specific color conversion layer and each absorption-type color filter layer formed directly thereon are easily formed in all subpixel area of the display panel according to an embodiment.

On the other hand, in order to selectively drive light emitting elements as described above, light emitting elements present in a subpixel including the same color conversion layer may be electrically connected to each other. Accordingly, the light emitting elements may be simultaneously driven to form the same color conversion layer.

The aforementioned photosensitive resin compositions for the color conversion layers 30R and 30G, the light transmission layer 30G and the absorption-type color filter layers 40R, 40G, and 40B may be negative type photosensitive resin compositions polymerized and cured by light emitted by the light emitting elements 20a, 20b, and 20c, for example, blue light having a central wavelength of about 430 nanometers to about 470 nanometers.

As described above, the method of fabricating the display panel according to an embodiment by driving the light emitting elements 20a, 20b, and 20c on the substrate 10 to expose and cure the photosensitive resin compositions without a separate exposure mask may easily form the color conversion layers 30R, 30G, and 30B and the absorption-type color filter layers 40R, 40G, and 40B and also, a pattern with a very narrow width. Accordingly, the display panel according to an embodiment may be advantageously applied to a display device employing each of very small light emitting elements such as micro light emitting diodes, nano light emitting diodes, or the like in each pixel to achieve high luminance and high color purity.

The display panel as described above may be applied to various electronic devices, and in particular, may be advantageously used in various display devices requiring miniaturization, weight reduction, and high resolution. Applicable display devices may include display devices in various fields such as televisions, monitors, mobile devices, watches, augmented reality ("VR")/virtual reality ("AR") applied game machines, signboards, and lighting, but are not limited thereto.

Hereinbefore, the certain exemplary embodiments of the present invention have been described and illustrated, however, it is apparent to a person with ordinary skill in the art that the present invention is not limited to the exemplary embodiment as described, and may be variously modified and transformed without departing from the scope of the present invention. Accordingly, the modified or transformed exemplary embodiments as such may not be understood separately from the technical ideas and aspects of the present invention, and the modified exemplary embodiments are within the scope of the claims of the present invention.

### <Description of Symbols>

| | | | |
|---|---|---|---|
| 100, 1000: | display panel, | | |
| 10, 1000D: | substrate, | | |
| 20, 20a, 20b, 20c: | light emitting element, | | |
| 30R, 30G: | color conversion layer including quantum dots, | | |
| 30B: | color conversion layer including not quantum dots or light transmission layer, | | |
| 40R, 40G, 40B: | absorption-type color filter layer, | | |
| 121R, 121G: | quantum dot, | 50: | overcoat layer, |
| 110: | partition wall, | 160: | protective layer, |
| 111: | buffer layer, | 124: | gate electrode, |
| 140: | gate insulating layer, | 154: | semiconductor layer, |

| | | | |
|---|---|---|---|
| 173: | source electrode, | 175: | drain electrode, |
| PR1, PR2, PR3, PR4, PR5, PR6: | photosensitive resin layer. | | |

## Claims

1. A display panel, comprising
a substrate;
a plurality of light emitting elements each comprising semiconductor light emitting chips and being disposed on the substrate;
a plurality of color conversion layers overlapped with and disposed on the plurality of light emitting elements, respectively; and
a plurality of absorption-type color filter layers directly disposed on and having a surface shape of the plurality of the color conversion layers, respectively,
wherein a pitch between adjacent light emitting elements of the plurality of light emitting elements is less than or equal to 100 micrometers, and
at least one of the plurality of color conversion layers comprises quantum dots.

2. The display panel of claim 1, wherein the plurality of color conversion layers comprise first color conversion layers comprising first quantum dots configured to convert light emitted from first light emitting elements of the plurality of light emitting elements into a first light of a first emission spectrum, and the first light emitting elements overlap with the first color conversion layer and are electrically connected to each other.

3. The display panel of claim 2, wherein the plurality of color conversion layers further comprise second color conversion layers comprising second quantum dots configured to convert light emitted from second light emitting elements of the plurality of light emitting elements into a second light of a second emission spectrum that differs from the first emission spectrum, and the second light emitting elements overlap with the second color conversion layers and are electrically connected to each other.

4. The method of claim 2, wherein the plurality of color conversion layers further comprise a plurality of light transmission layers configured to transmit a third light of an emission spectrum emitted from third light emitting elements of the plurality of light emitting elements as it is, and the third light emitting elements overlap with the plurality of light transmission layers and are electrically connected to each other.

5. The display panel of any preceding claim, wherein a central wavelength of light emitted by each of the plurality of light emitting elements is 430 nanometers to 470 nanometers.

6. The display panel of any preceding claim, wherein each of the plurality of absorption-type color filter layers comprises a pigment, a dye, or a combination thereof.

7. The display panel of any preceding claim, wherein the plurality of absorption-type color filter layers comprise a photo initiator.

8. The display panel of any preceding claim, wherein
the plurality of light emitting elements comprise a plurality of micro light emitting diodes which emit blue light, and
the plurality of color conversion layers comprise first color conversion layers comprising red light-emitting quantum dots dispersed in a polymer matrix, and second color conversion layers comprising green light-emitting quantum dots dispersed in a polymer matrix.

9. A method of fabricating a display panel, comprising
preparing a substrate comprising a plurality of light emitting elements thereon and a first color conversion layer comprising first quantum dots, wherein each of the plurality of light emitting elements comprises semiconductor light emitting chip, and the first color conversion layer is disposed on a first light emitting element of the plurality of light emitting elements,
forming a first photosensitive resin layer comprising a pigment, a dye, or a combination thereof of a first color on the first color conversion layer, and
driving the first light emitting element on which the first color conversion layer is disposed to cure the first photosensitive resin layer with light emitted from the first light emitting element to form a first absorption-type color filter layer on the first color conversion layer.

10. The method of claim 9, wherein a central wavelength of light emitted by each of the plurality of light emitting elements is 430 nanometers to 470 nanometers.

11. The method of claim 9 or 10, wherein the substrate comprising the first color conversion layer further comprises a second color conversion layer comprising second quantum dots and disposed on a second light emitting element of the plurality of light emitting elements, which is different from the first light emitting element.

12. The method of claim 11, further comprising:
forming a second photosensitive resin layer comprising a pigment, a dye, or a combination thereof of a second color on the second color conversion layer, and
driving the second light emitting element on which the second color conversion layer is disposed to cure the second photosensitive resin layer with light emitted from the second light emitting element to form a second absorption-type color filter layer on the second color conversion layer.

13. The method of claim 12, wherein the substrate further comprises a light transmission layer disposed on a third light emitting element of the plurality of light emitting elements, which is different from the first and second light emitting elements.

14. The method of claim 13, further comprising:
(i) after forming a third photosensitive resin layer comprising a pigment, a dye, or a combination thereof of a third color on the light transmission layer, driving the third light emitting element on which the light transmission layer is disposed to cure the third photosensitive resin layer with light emitted from the third light emitting element to form a third absorption-type color filter layer on the light transmission layer;
(ii) after forming a second photosensitive resin layer comprising a pigment, a dye, or a combination thereof of a second color on the second color conversion layer, driving the second light emitting element on which the second color conversion layer is disposed to cure the second photosensitive resin layer with light emitted from the second light emitting element to form a second absorption-type color filter layer on the second color conversion layer; or
(iii) performing both processes (i) and (ii) to form both the third absorption-type color filter layer and the second absorption-type color filter layer.

15. The method of claim 13, wherein each of the first, second and third light emitting elements, the first and second color conversion layers, and the light transmission layer is provided in plurality,
wherein the plurality of first light emitting elements are formed on the first color conversion layers, the plurality of second light emitting elements are formed on the second color conversion layers, and the plurality of third light emitting elements are formed on the light transmission layers,
wherein the plurality of first light emitting elements are electrically connected to each other, the plurality of second light emitting elements are electrically connected to each other, and the plurality of third light emitting elements are electrically connected to each other.
